Europäisches Patentamt

European Patent Office

Office européen des brevets

(11) Publication number: **0 110 296**
**B1**

# EUROPEAN PATENT SPECIFICATION

(45) Date of publication of patent specification: **08.02.89**

(21) Application number: **83111658.7**

(22) Date of filing: **22.11.83**

(51) Int. Cl.⁴: **H 03 K 3/03**

(54) **Voltage controlled oscillator.**

(30) Priority: **24.11.82 JP 204638/82**

(43) Date of publication of application:
**13.06.84 Bulletin 84/24**

(45) Publication of the grant of the patent:
**08.02.89 Bulletin 89/06**

(84) Designated Contracting States:
**DE GB**

(56) References cited:
**FR-A-2 312 396**
**US-A-4 129 833**

**MACHINE DESIGN, vol. 46, no. 27, 14th
November 1974, page 166; "Superprecise"
EDN, vol. 23, no. 1, 5th January 1978, page 86,
Cahners Publishing Co., Denver, US;
V.R.LAUL: "NOR-gate circuit eases testing
tasks"**

(73) Proprietor: **HITACHI, LTD.**
**6, Kanda Surugadai 4-chome Chiyoda-ku
Tokyo (JP)**

(72) Inventor: **Mori, Yonemitsu**
**c/o Fujimiryo 1545, Yoshidacho
Totsuka-ku Yokohama (JP)**
Inventor: **Ikoma, Junichi**
**3-3, Uragaoka-2-chome
Yokosuka-shi (JP)**

(74) Representative: **Altenburg, Udo, Dipl.-Phys.
et al
Patent- und Rechtsanwälte Bardehle-
Pagenberg-Dost-Altenburg & Partner Postfach
86 06 20
D-8000 München 86 (DE)**

Courier Press, Leamington Spa, England.

## Description

The present invention relates to a voltage controlled oscillator according to the preamble of Claim 1. Such an oscillator is known from the FR—2 312 396.

This citation shows two inverters connected in series, wherein the input of the first inverter and the output of the second are connected via a first resistor and a capacitor, a second resistor being provided between the connection point of the two inverters and the connection point of said first resistor and said capacitor. Such a circuit acts as an oscillator.

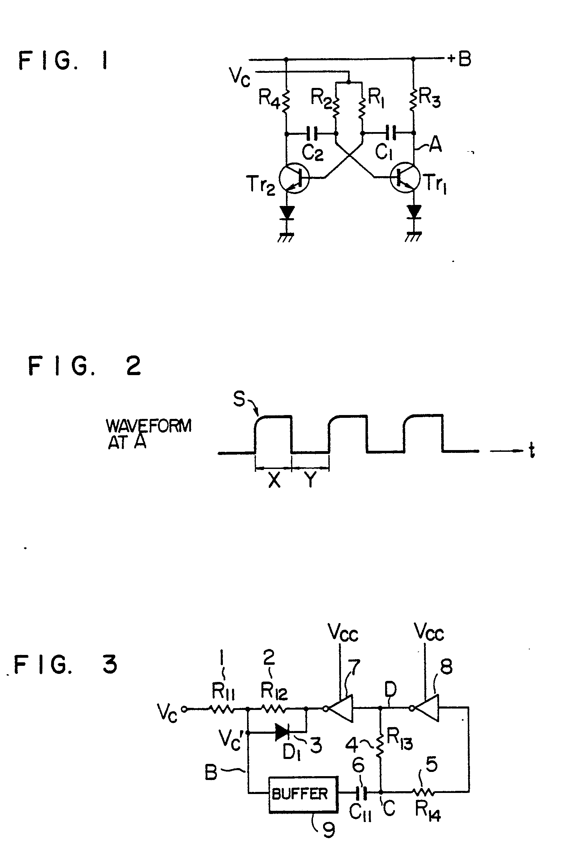

Figure 1 shows a circuit diagram of a prior art voltage controlled oscillator and Figure 2 shows an oscillation output waveform of the oscillator of Figure 1 at a point A.

The circuit of Figure 1 constitutes a well-known astable mutlivibrator in which a first transistor $Tr_1$ and a second transistor $Tr_2$ are alternately turned on and off and an oscillation output frequency f is determined by a time constant of a capacitor $C_1$ and a resistor $R_1$, and a time constant of a capacitor $C_2$ and a resistor $R_2$. Such a voltage controlled oscillator is shown in "Pulse Circuit" by K. Gotoh on pages 149—157, published by Sangyo Tosho Co., Ltd. in 1978, October.

Referring to the waveform of Figure 2, a period X is determined by the time constant of $R_2$ and $C_2$ and a period Y is determined by the time constant of $R_1$ and $C_1$. Thus, two time constant circuits ($R_1$, $C_1$) and ($R_2$, $C_2$) are necessary to determine the oscillation output frequency f.

Assuming that $K_1$ and $K_2$ are constants, the oscillation output frequency f is given by

$$f=\frac{1}{X+Y} \qquad (1)$$

$$X+Y=K_1 \cdot R_1 \cdot C_1+K_2 \cdot R_2 \cdot C_2 \qquad (2)$$

for a given control voltage Vc. From the equations (1) and (2),

$$f=\frac{1}{X+Y}=\frac{1}{K_1 \cdot R_1 \cdot C_1+K_2 \cdot R \cdot C_2} \qquad (3)$$

Usually, since $K_1=K_2=K$

$$f=\frac{1}{X+Y}=\frac{1}{K(R_1 \cdot C_1+R_2 \cdot C_2)} \qquad (4)$$

By varying the magnitude of the control voltage Vc, the charge target voltages of the capacitors change and hence the periods X and Y change so that a variable frequency output is produced.

Such a prior art voltage controlled oscillator has the following disadvantages.

First, when a power supply +B is turned on, an astable condition may not be established by some reason and both the transistors $Tr_1$ and $Tr_2$ are turned on in a stable state. In such a case, the oscillation starts if one of the transistor circuits is shorted to artificially create an unbalanced condition. Thus, the prior art voltage controlled oscillator has a possibility of stop of oscillation and lacks a reliability in the oscillation operation.

Secondly, as a problem inherent to the circuit of the prior art voltage controlled oscillator, a shoulder S of a leading edge of the output waveform is dull as seen from Figure 2 and an exact square wave is difficult to achieve. Such a dull edge is produced because the capacitor $C_1$ is charged through the resistor $R_3$ when the first transistor $Tr_1$ is turned off from its on state, that is, the dull edge is produced when the output changes from a low level (L) to a high level (H). In order to suppress the dull edge, the resistance values of the collector resistors $R_3$ and $R_4$ may be reduced but it creates another problem of increase of a power consumption in the circuit.

Furthermore, the prior art circuit also requires two sets of time constant circuits ($R_1$, $C_1$ and $R_2$, $C_2$).

It is a primary object of the present invention to provide a voltage controlled oscillator which is highly reliable in operation, consumes a low power and produces an exact square wave output.

It is a secondary object of the present invention to provide an economic voltage controlled oscillator which has a reduced number of time constant circuit, and is simple in circuit configuration.

In accordance with the present invention this is achieved by a voltage controlled oscillator according to Claim 1. An input terminal of a first inverting amplifier and an output terminal of a second inverting amplifier are connected (the junction point thereof being referred to as a first junction point), an output terminal of the first inverting amplifier is connected to a voltage control input terminal through a series circuit of a second resistor and a third resistor (the junction point thereof being referred to as a second junction point), the second junction point is connected to one end of a capacitor directly or through a buffer for impedance conversion, the other end of the capacitor is connected to an input terminal of the second inverting amplifier and to the first junction point through a first resistor which forms a time constant circuit together with the capacitor, and a voltage clamp means is connected between the second junction point and the output terminal of the first inverting amplifier or between the second junction point and the output terminal of the second inverting amplifier so that an oscillation ouptut of a variable frequency is produced at the output terminal of the first inverting amplifier or at the output terminal of the second inverting amplifier in accordance with a variable voltage applied to the voltage control input terminal.

Preferred embodiments of the prsent invention are mentioned in the subclaims.

The present invention will be apparent from the following detailed description taken in conjunction with the accompanying drawings, in which:

Figure 1 shows a circuit diagram of a prior art voltage controlled oscillator;

Figure 2 shows an oscillation output waveform of the oscillator of Figure 1;

Figure 3 shows a circuit diagram of one embodiment of the present invention;

Figure 4 shows signal waveforms in the circuit of Figure 3;

Figure 5 shows potential values in the circuit of Figure 3;

Figure 6 shows an oscillation frequency characteristic of the circuit of Figure 3; and

Figures 7, 8A, 8B and 8C show circuit diagrams of other embodiments of the present invention.

Figure 3 shows a circuit diagram of one embodiment of the voltage controlled oscillator of the present invention. Vc denotes an oscillation frequency control voltage, Vcc denotes a power supply voltage, numerals 1 and 2 denote a second resistor $R_{11}$ and a third resistor $R_{12}$, respectively, for determining a control sensitivity, numeral 3 denotes a clamping diode $D_1$ for fixing the control voltage Vc', numeral 4 denotes a first resistor $R_{13}$, numeral 5 denotes a protecting resistor $R_{14}$, numeral 6 denotes a capacitor $C_{11}$, numeral 7 denotes a first inverter, numeral 8 denotes a second inverter, and numeral 9 denotes a buffer which functions as an impedance converter for converting an impedance as looked from the capacitor 6 into the resistors 1 and 2, which impedance would be high if the buffer 9 were not present, to a low impedance in order to prevent the affect by the resistors 1 and 2 to the oscillation frequency determined by the time constant of the capacitor 6 and the resistor 4. The buffer 9 and the protecting resistor 5 may be omitted in the embodiment of the present invention.

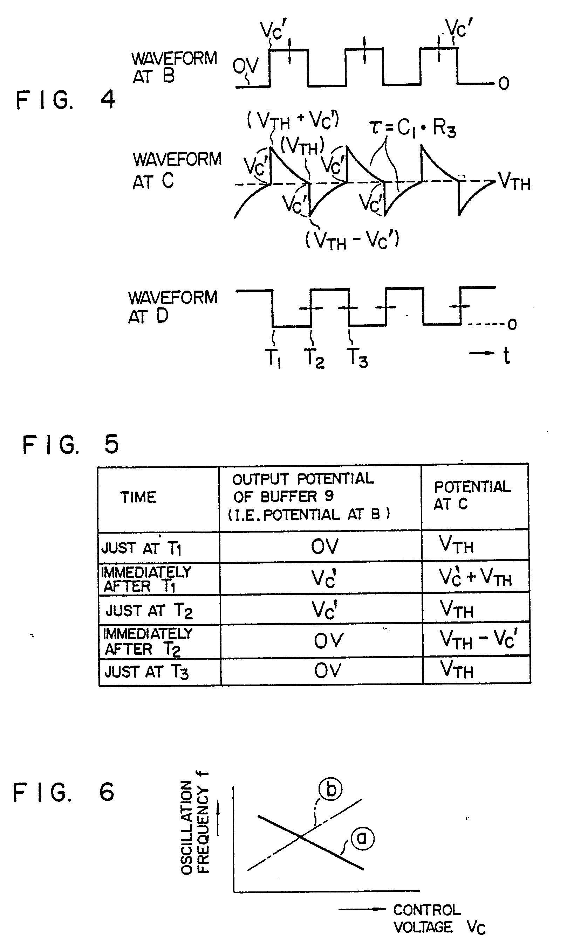

Figure 4 shows signal waveforms at points B, C and D in the circuit of Figure 3. $V_{TH}$ denotes a threshold level in the input circuit at which the output level of the second inverter 8 changes from a high level (H) to a low level (L) or vice versa.

Referring to Figures 3 and 4, the operation of the voltage controlled oscillator of the present embodiment will be explained. Assuming that the output level of the first inverter 7 is L (OV), the potential at the point B is OV by the function of the diode 3. Since the output level of the second inverter 8 is now H, a charging current flows into the capacitor $C_{11}$ through the first resistor 4 and a charge voltage rises toward the power supply voltage Vcc of the inverter 7 and 8.

As a result, when the potential at the point C reaches the threshold voltage $V_{TH}$, the output level of the second inverter 8 changes to L and hence the output level of the first inverter 7 changes to H. The potential Vc' at the point B is given by

$$Vc'=(Vcc-Vc)\times\frac{R_{11}}{R_{11}+R_{12}}+Vc \qquad (5)$$

where $R_{11}$ is a resistance value of the resistor 1 and $R_{12}$ is a resistance value of the resistor 2.

Thus, the potential on one electrode of the capacitor 6 (connected to the buffer 9) rapidly increases from OV to Vc' and the potential at the point C reaches ($V_{TH}+Vc'$). The input level of the second inverter 8 further increases. Since the output level thereof is L, the charge in the capacitor 6 is discharged through the first resistor 4 and the potential at the point C falls toward OV. When the potential at the point C reaches the threshold voltage $V_{TH}$, the output level of the second inverter 8 changes to H and the output level of the first inverter 7 changes to L (OV). The potential at the point B is OV by the function of the diode 3. As a result, the output potential of the buffer 9 rapidly falls from Vc' to OV, and the potential at the point C falls from $V_{TH}$ to ($V_{TH}-Vc'$) and the capacitor 6 is charged through the first resistor 4. The above operations are repeated.

Namely, the output potential of the buffer 9 (i.e., the potential at the point B) and the potential at the point C change with time as shown in Table of Figure 5 so that the circuit oscillates. As seen from Figure 4, the waveform of the maximum potential at the point C is higher than the threshold $V_{TH}$ of the inverter 8 by Vc' and that of the minimum potential is lower than $V_{TH}$ by Vc'. Thus, the capacitor 6 is discharged with the time constant $\tau=C_{11}\cdot R_{13}$ when the potential at the point C is between $V_{TH}+Vc'$ and $V_{TH}$, and is charged with the same time constant $\tau$ when the potential is between $V_{TH}$ and $V_{TH}-Vc'$, where $C_{11}$ is a capacitance of the capacitor 6 and $R_{13}$ is a resistance value of the resistor 4.

Since the time constant $\tau$ is constant, the higher is the voltage Vc' appearing at the point B depending on the control voltage Vc, the lower is the oscillation frequency f, and the lower the Vc' is, the higher is the oscillation frequency f, as is readily seen from the potential waveform at the point C of Figure 4. This relation is shown by a solid line ⓐ in Figure 6.

In Figure 3, the resistor 5 is the input protecting resistor of a high impedance. It is inserted because the potential at ohe point C may be higher than the power supply voltage Vcc of the inverter 8 or lower than the ground (GND) potential.

Since no capacitor is connected to the output terminal of the first inverter 7, the output waveform of the first inverter 7 does not become dull as is the case of S shown in Figure 2. Accordingly, all resistors may be of high resistance and hence a power consumption is low.

In the description of the circuit of Figure 3, the potential at the point B is fixed to the L level of the inverter 7 by the diode 3. Alternatively, the potential at the point B may be fixed to the H level by reversing the polarity of the diode 3 and the lower potential side thereof varied by the control voltage Vc. In this case, as the control voltage Vc increases, the oscillation frequency f increases and a characteristic shown by a broken line ⓑ in Figure 6 is obtained.

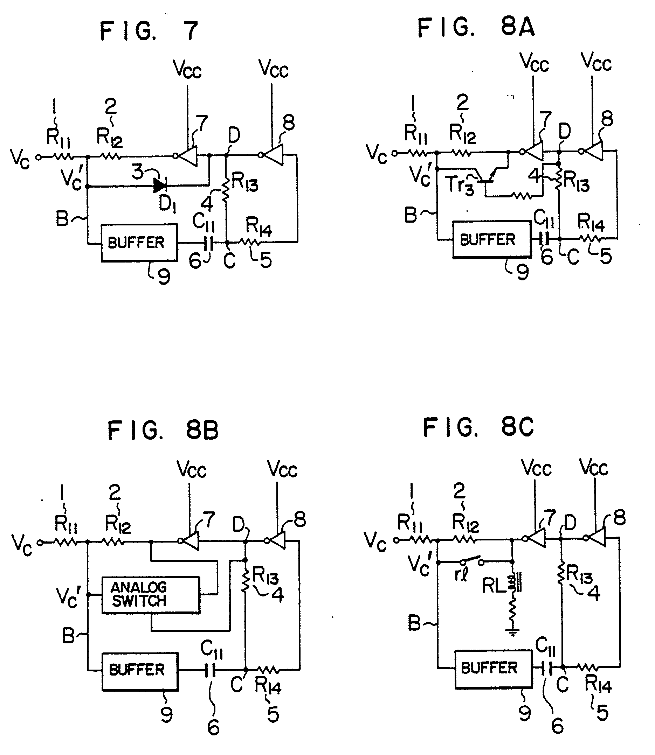

Figure 7 shows anotmer embodiment of the voltage controlled oscillator of the present invention. In the first embodiment shown in Figure 3, the clamp diode 3 is connected between the junction point of the resistor 1 and the resistor 2, and the output terminal of the first inverter 7. In Figure 7, the clamp diode 3 is connected between the junction point of the resistors 1 and 2 and the output terminal of the second inverter 8. In this case, the same output waveforms at the points B, C and D as those shown in Figure 4 are produced and the same function and effect are attained.

The clamp means for fixing the voltage may be a transistor $Tr_3$, an analog switch or a mechanical switch RL as shown in Figures 8A, 8B and 8C, respectively, instead of the diode 3.

As described hereinabove, the present invention provides a voltage controlled oscillator which is highly reliable in operation, consumes low power and produces an inherently exact square wave output while using only one set of time constant circuit.

**Claims**

1. A voltage controlled oscillator comprising:
a first inverter (7) having an output terminal;
a second inverter (8) having an output terminal thereof connected to an input terminal of said first inverter (7);
a first resistor (4) having one terminal connected to the output terminal of said second inverter (8);
a capacitor (6) connected to said first resistor (4), said capacitor (6) forming a time constant circuit together with said first resistor (4); characterized by
a series circuit of a second resistor (1) and a third resistor (2), the third resistor being connected to the output of said first inverter (7), wherein an oscillation frequency control voltage (Vc) is applied to said second resistor (1), and wherein a junction point of said second resistor (1) and said third resistor (2) is connected to said capacitor (6);
clamp means (3) connected between the junction point of said second resistor (1) and said third resistor (2) and the output terminal of said first inverter (7) or between the junction point of said second resistor (1) and said third resistor (2) and the input terminal of said first inverter (7) for fixing a voltage at the junction point of said second resistor (1) and said third resistor (2) to a predetermined voltage during the period of "high voltage" or the period of "low voltage" of the output of said first inverter (7), whereby an oscillation output of a variable frequency is produced at the output terminal of said first inverter (7) or at the output terminal of said second inverter (8).

2. A voltage controlled oscillator according to Claim 1 further comprising a buffer (9) for impedance conversion connected between the junction point of said second resistor (1) and said third resistor (2), and said capacitor (6).

3. A voltage controlled oscillator according to Claim 1 further comprising a protecting resistor (5) connected between the input terminal of said second inverter (8) and said capacitor (6).

4. A voltage controlled oscillator according to Claim 1 wherein said clamp means (3) is a diode.

5. A voltage controlled oscillator according to Claim 1 wherein said clamp means (3) is a transistor.

6. A voltage controlled oscillator according to Claim 1 wherein said clamp means (3) is an analog switch.

7. A voltage controlled oscillator according to Claim 1 wherein said clamp means (3) is a mechanical switch.

**Patentansprüche**

1. Spannungs-gesteuerter Oscillator, der aufweist:
einen ersten Inverter (7) mit einem Ausgangsanschluß;
einen zweiten Inverter (8), der einen Ausganganschluß hat, welcher mit einem Eingangsanschluß des ersten Inverters (7) verbunden ist;
einen ersten Widerstand (4), der einen Anschluß hat, welcher mit dem Ausgangsanschluß des zweiten Inverters (8) verbunden ist;
einen Kondensator (6), der mit dem ersten Widerstand (4) verbunden ist, wobei der Kondensator (6) eine Zeitkonstante-Schaltung zusammen mit dem ersten Widerstand (4) bildet; gekennzeichnet durch
eine Serienschaltung aus einem zweiten Widerstand (1) und einem dritten Widerstand (2), wobei der dritte Widerstand mit dem Ausgang des ersten Inverters (7) verbunden ist, und eine Oszillationsfrequenz-Steuerspannung (Vc) an den zweiten Widerstand (1) angelegt ist, und wobei ein Verbindungspunkt des zweiten Widerstandes (1) und des dritten Widerstands (2) mit dem Kondensator (6) verbunden ist;
eine Klammereinrichtung (3), welche zwischen dem Verbindungspunkt des zweiten Widerstands (1) und des dritten Widerstands (2) und dem Ausgangsanschluß des ersten Inverters (7) oder zwischen dem Verbindungspunkt des zweiten Widerstands (1) und des dritten Widerstands (2) und dem Eingangsanschluß des ersten Inverters (7) geschaltet ist, um eine Spannung an dem Verbindungspunkt des zweiten Widerstands (1) und des dritten Widerstands (2) während des Zeitabschnitts der "oberen Spannung" oder des Zeitabschnitts der "unteren Spannung" des Ausgangs des ersten Inverters (7) auf einer vorgegebenen Spannung festzuhalten, wobei ein Oszillationsausgang mit einer variablen Frequenz an dem Ausgangsanschluß des ersten Inverters (7) oder an dem Ausgangsanschluß des zweiten Inverters (8) erzeugt wird.

2. Spannungs-gesteuerter Oszillator nach Anspruch 1, ferner aufweisend einen Puffer (9) zur Impedanzwandlung, der zwischen dem Verbindungspunkt des zweiten Widerstands (1) und des dritten Widerstands (2) und dem Kondensator (6) geschaltet ist.

3. Spannungs-gesteuerter Oszillator nach Anspruch 1, ferner aufweisend einen Schutzwiderstand (5), welcher zwischen dem Eingangsanschluß des zweiten Inverters (8) und dem Kondensator (6) geschaltet ist.

4. Spannungs-gesteuerter Oszillator nach Anspruch 1, wobei die Klemmeinrichtung (3) eine Diode ist.

5. Spannungs-gesteuerter Oszillator nach Anspruch 1, wobei die Klemmeinrichtung (3) ein Transistor ist.

6. Spannungs-gesteuerter Oszillator nach Anspruch 1, wobei die Klemmeinrichtung (3) ein analoger Schalter ist.

7. Spannungs-gesteuerter Oszillator nach Anspruch 1, wobei die Klemmeinrichtung (3) ein mechanischer Schalter ist.

## Revendications

1. Oscillateur commandé par la tension, cmprenant:

un premier inverseur (7) possédant une borne de sortie;

un second inverseur (8) dont une borne de sortie est raccordée à une borne d'entrée dudit premier inverseur (7);

une première résistance (4), dont une borne est raccordée à la borne de sortie dudit second inverseur (8);

un condensateur (6) raccordé à ladite première résistance (4), ledit condensateur (6) formant, en association avec ladite première résistance (4), un circuit fournissant une constante de temps; caractérisé par

un circuit série formé d'une seconde résistance (1) et d'une troisième résistance (2), la troisième résistance étant raccordée à la sortie dudit premier inverseur (7, une tension (Vc) de commande de la fréquence d'oscillation étant appliquée à ladite seconde résistance (1), et un point de jonction de ladite seconde résistance (1) et de ladite troisième résistance (2) étant raccordé audit condensateur (6);

des moyens de verrouillage (3) branchés entre le point de jonction de ladite seconde résistance (1) et de ladite troisième résistance (2) et la borne de sortie dudit premier inverseur (7) ou entre le point de jonction de ladite seconde résistance (1) et de ladite troisième résistance (2) et la borne d'entrée dudit premier inverseur (7) pour la détermination d'une tension au niveau du point de jonction de ladite seconde résistance (1) et de ladite troisième résistance (2) à une valeur prédéterminée pendant la période à "haute tension" ou pendant la période à "basse tension" de la sortie du premier inverseur (7), ce que a pour effet qu'un signal de sortie oscillatoire à fréquence variable est produit sur la borne de sortie dudit premier inverseur (7) ou sur la borne de sortie dudit second inverseur (8).

2. Oscillateur commandé par la tension selon la revendication 1, comportant en outre un tampon (9) servant à réaliser une adaptation d'impédance et branché entre le point de jonction de ladite seconde résistance (1) et de ladite troisième résistance (2), et ledit condensateur (6).

3. Oscillateur commandé par la tension selon la revendication 1, comportant en outre une résistance de protection (5) branchée entre la borne d'entrée dudit second inverseur (8) et ledit condensateur (6).

4. Oscillateur commandé par la tension selon la revendication 1, dans lequel lesdits moyens de verrouillage (3) sont formés par une diode.

5. Oscillateur commandé par la tension selon la revendication 1, dans lequel les moyens de verrouillage (3) sont formés par un transistor.

6. Oscillateur commandé par la tension selon la revendication 1, dans lequel lesdits moyens de verouillage (3) sont formés par un interrupteur analogique.

7. Oscillateur commandé par la tension selon la revendication 1, dans lequel lesdits moyens de verrouillage (3) sont formés par un interrupteur mécanique.

FIG. 1

FIG. 2

WAVEFORM
AT A

FIG. 3

1

FIG. 4

WAVEFORM AT B

$V_C'$        $V_C'$

0V                    0

WAVEFORM AT C

$(V_{TH} + V_C')$

$(V_{TH})$

$\tau = C_1 \cdot R_3$

$V_C'$      $V_C'$               $V_{TH}$

$V_C'$      $V_C'$

$(V_{TH} - V_C')$

WAVEFORM AT D

$T_1$   $T_2$   $T_3$        0

                       $\longrightarrow t$

FIG. 5

| TIME | OUTPUT POTENTIAL OF BUFFER 9 (I.E. POTENTIAL AT B ) | POTENTIAL AT C |
|---|---|---|
| JUST AT $T_1$ | 0V | $V_{TH}$ |
| IMMEDIATELY AFTER $T_1$ | $V_C'$ | $V_C' + V_{TH}$ |
| JUST AT $T_2$ | $V_C'$ | $V_{TH}$ |
| IMMEDIATELY AFTER $T_2$ | 0V | $V_{TH} - V_C'$ |
| JUST AT $T_3$ | 0V | $V_{TH}$ |

FIG. 6

OSCILLATION FREQUENCY $f$

ⓑ

ⓐ

$\longrightarrow$ CONTROL VOLTAGE $V_C$

# FIG. 7

# FIG. 8A

# FIG. 8B

# FIG. 8C